# FASCICULE DE BREVET EUROPEEN

(11) **EP 2 423 160 B1**
(45) Date de publication et mention de la délivrance du brevet: **16.07.2014**
(21) Numéro de dépôt: 11178878.2
(22) Date de dépôt: 25.08.2011
(51) Int. Cl.: B81C 3/00, H01L 23/10

(54) **Assemblage d'objets par l'intermédiaire d'un cordon de scellement comportant des composés intermetalliques**
Verbindung von Gegenständen mittels einer Versiegelungsnaht, die intermetallische Verbindungen umfasst
Assembly of objects by means of a sealing bead comprising intermetallic compounds

(30) Priorité: 31.08.2010 FR 1056883
(43) Date de publication de la demande: 29.02.2012
(73) Titulaire: Commissariat à l'Énergie Atomique et aux Énergies Alternatives, 75015 Paris (FR)
(72) Inventeur: Sibuet, Henri, 38500 LA BUISSE (FR); Baillin, Xavier, 38920 CROLLES (FR); Sillon, Nicolas, 38120 SAINT EGREVE (FR)
(74) Mandataire: Ilgart, Jean-Christophe

(56) Documents cités:
- WO-A1-96/19314
- WO-A2-01/86715
- US-A1- 2004 112 478
- WARREN C WELCH ET AL: "Gold-indium Transient Liquid Phase (TLP) wafer bonding for MEMS vacuum packaging", IEEE 21ST INTERNATIONAL CONFERENCE ON MICRO ELECTRO MECHANICAL SYSTEMS, 2008 : MEMS 2008 ; 13 - 17 JAN. 2008, TUCSON, ARIZONA, USA, PISCATAWAY, NJ : IEEE OPERATIONS CENTER, 1 janvier 2008 (2008-01-01), pages 806-809, XP031210869, ISBN: 978-1-4244-1792-6

## Description

### DOMAINE TECHNIQUE

La présente invention se rapporte au domaine de l'assemblage d'objets, notamment pour la microélectronique. L'invention s'applique particulière pour la réalisation de packaging, ou encapsulation, de microsystèmes, ou microcomposants, de type MEMS (microsystèmes électromécaniques), NEMS (nanosystèmes électromécaniques) ou encore MOEMS (microsystèmes opto-électromécaniques), dans des cavités hermétiques formées entre un support et un capot.

### ÉTAT DE LA TECHNIQUE ANTÉRIEURE

Un packaging d'un microsystème permet de protéger ce microsystème des agressions extérieures compte tenu de ses petites dimensions, de le manipuler sans risque lors d'une intégration dans un dispositif électronique, ou encore de l'encapsuler sous atmosphère contrôlée. Un tel packaging comporte une opération d'assemblage entre un support sur lequel est préalablement réalisé le microsystème et un capot, encapsulant le microsystème dans une cavité formée entre le support et le capot. Pour des raisons de coût, cet assemblage est généralement réalisé de manière collective pour plusieurs microsystèmes réalisés sur le support. Le support est généralement un substrat, c'est-à-dire une galette (ou wafer) de semi-conducteur de diamètre pouvant aller jusqu'à environ 300 mm. Le capot peut également être formé par un second substrat.

Les puces ainsi obtenues (un puce correspondant à un microsystème encapsulé dans sa cavité) sont ensuite séparées les unes des autres par une opération de découpe du support (et éventuellement du capot si celui-ci est commun à plusieurs puces). Un tel assemblage du capot au support doit donc être robuste mécaniquement et, lorsque le microsystème est encapsulé sous atmosphère contrôlée, hermétique afin d'éviter tout échange gazeux avec l'extérieur de la cavité.

Cet assemblage entre le support et le capot est par exemple réalisé par l'intermédiaire d'un cordon de scellement métallique qui assure une cohésion et un maintien mécanique entre le support et le capot, tout en formant les parois latérales de la cavité. Le cordon métallique est généralement réalisé à partir d'un métal de brasage, par exemple de l'étain ou un alliage à base d'étain.

Toutefois, l'utilisation d'un tel cordon métallique a pour inconvénient qu'après la réalisation de assemblage entre le support et le capot par l'intermédiaire du cordon métallique, il n'est pas possible de mettre en oeuvre des étapes technologiques impliquant des budgets thermiques supérieurs à la température de fusion, ou point de fusion, du métal de brasage sous peine de faire fondre de nouveau le cordon métallique et donc de détruire le packaging précédemment réalisé.

Pour palier à cet inconvénient, il est possible de réaliser l'assemblage entre le support et le capot en mettant en oeuvre un procédé de brasage par solidification isotherme, appelé aussi TLPB (« Transient Liquid Phase Bonding » en anglais, ou adhésion par phase liquide transitoire). Ce type de brasage consiste à faire fondre le métal de brasage, qui peut être un métal pur ou un alliage, en contact avec un autre métal dont le point de fusion, ou température de fusion, est supérieur à celui du métal de brasage et qui réagit avec le métal de brasage en phase liquide de façon à en modifier la composition chimique. Cette réaction chimique forme des composés intermétalliques (IMC) qui conduisent à la consommation totale du métal de brasage fondu. Ainsi, l'intégralité du métal de brasage est transformée chimiquement en IMC qui forme la brasure. Ces IMC ont une composition chimique correspondant à la combinaison du métal de brasage et du métal de plus haut point de fusion, et comportent une structure cristallographique différente des structures cristallographiques du métal de brasage et du métal de plus haut point de fusion.

A titre d'exemple, il est possible d'utiliser de l'étain (métal de brasage) que l'on fait fondre entre deux couches de nickel (métal de plus haut point de fusion), ces couches étant réalisées selon un motif correspondant à celui du cordon de scellement à réaliser. L'une des deux couches de nickel est préalablement réalisée sur une face du support et l'autre des deux couches de nickel est préalablement réalisée sur une face du capot, ces faces étant destinées à être en regard l'une de l'autre une fois l'assemblage terminé. Au cours du brasage, l'étain réagit avec le nickel pour former des IMC de phase (Sn, Ni) dont la structure cristallographique est différente de celles de l'étain et du nickel, et dont la température de fusion est supérieure à celle de l'étain qui est d'environ 232°C. On obtient ainsi un cordon de scellement métallique formé par la superposition d'au moins trois couches métalliques, à savoir au moins une couche de phase intermétallique (Sn, Ni) disposée entre deux couches de nickel, ces couches étant parallèles au support et au capot.

Toutefois, bien que ces IMC permettent d'augmenter le point de fusion du cordon de scellement réalisé et compte tenu du fait qu'ils soient disposés en couches parallèles au substrat, ou au support, et liés les uns aux autres, définissant ainsi des interfaces entre IMC potentiellement fragiles, ils fragilisent mécaniquement le cordon de scellement. Ceci peut donc poser des problèmes notamment dans le cas d'une encapsulation d'un microsystème qui nécessite une bonne tenue mécanique de l'assemblage réalisé.

Le document de W. C. Welch et al., « Gold-indium transient liquid phase (TLP) wafer bonding for MEMS vacuum Packaging »; IEEE 21st International Conférence on Micro Electro Mechanical Systems, 2008: MEMS 2008; 13-17 janvier 2008, Tucson, Arizona, USA, Piscataway, NJ: IEEE Opérations Center 1er janvier 2008; pages 806-809, décrit un procédé d'assemblage de deux objets, comportant les étapes de :
- réalisation d'un élément de brasage formé d'un premier métal de brasage,
- mise en contact de l'élément de brasage avec un deuxième métal dont le point de fusion est supérieur à celui du premier métal de brasage,
- brasage des deux objets par solidification isotherme de l'élément de brasage, formant un élément de liaison disposé entre les deux objets, ledit élément de liaison comportant une portion de matériau comprenant des composés intermétalliques d'une phase formée du premier métal de brasage et du deuxième métal.

### EXPOSÉ DE L'INVENTION

Un but de la présente invention est de proposer un nouveau type d'assemblage de deux objets présentant l'avantage apporté par les composés intermétalliques, à savoir augmenter le point de fusion de l'élément de liaison entre les deux objets, tout en évitant une fragilisation mécanique l'assemblage.

Pour cela, la présente invention propose un assemblage de deux objets solidarisés l'un à l'autre par au moins un élément de liaison disposé entre les deux objets, ledit élément de liaison comportant au moins une première portion de matériau comprenant des composés intermétalliques d'une phase formée d'un premier métal de brasage et d'un deuxième métal dont le point de fusion est supérieur à celui du premier métal de brasage, ledit élément de liaison comportant en outre au moins une seconde portion de matériau composée d'au moins un troisième métal, ladite seconde portion de matériau étant en contact avec les deux objets.

L'invention propose donc un assemblage de deux objets par un élément de liaison comportant des IMC, ces IMC permettant d'augmenter le point de fusion de l'élément de liaison par rapport au point de fusion du métal de brasage utilisé pour former ces IMC. De plus, grâce à la seconde portion de matériau à base du troisième métal, qui peut ne pas comporter d'IMC ou comporter des IMC différents de ceux de la première portion de l'élément de liaison et pouvant être choisis tels qu'ils offrent de meilleures propriétés en termes de solidité mécanique, et qui est en contact avec les deux objets (ce contact étant direct entre les deux objets, c'est-à-dire un contact réalisé sans l'intermédiaire des IMC de la première portion de l'élément de liaison), les IMC présents dans la ou les premières portions de matériau de l'élément de liaison ne fragilisent pas mécaniquement l'élément de liaison compte tenu de la liaison mécanique formée par cette seconde portion de matériau entre les deux objets. Ainsi, par rapport à un élément de liaison réalisé sous la forme de couches superposées et parallèles aux objets, la structure de l'élément de liaison selon l'invention permet d'obtenir une plus grande solidité mécanique.

Il est possible que le troisième métal soit un alliage du deuxième métal et de l'un des composants de l'alliage de brasage (cas d'un alliage de brasage de composition eutectique).

Un tel assemblage offre une tenue mécanique permettant par exemple de réaliser sur l'assemblage une ou plusieurs opérations de rectification mécanique en vue notamment de réduire l'épaisseur d'au moins l'un des deux objets, et/ou une découpe ultérieure des objets.

De plus, lorsque l'élément de liaison est hermétique, l'étanchéité de l'assemblage permet de faire subir à l'assemblage des opérations technologiques par voie humide.

On entend par « composés intermétalliques », ou IMC, des composés dont la composition chimique correspond à la combinaison d'au moins deux éléments métalliques différents, et comportant une structure cristallographique différente des structures cristallographiques de chacun des éléments métalliques.

Dans un premier mode de réalisation, l'assemblage peut comporter au moins deux premières portions de matériau comprenant les composés intermétalliques, les deux premières portions de matériau étant en contact avec les deux objets, la seconde portion de matériau étant disposée entre les deux premières portions de matériau.

Dans ce cas, l'assemblage peut comporter en outre au moins deux parois métalliques à base du deuxième métal et en contact avec au moins l'un des deux objets, chacune des deux premières portions de matériau étant disposée entre la seconde portion de matériau et l'une des deux parois métalliques. Les deux parois métalliques, qui ont une géométrie qui peut être définie en fonction de la géométrie souhaitée des premières portions de matériau au sein de l'élément de liaison, peuvent donc contrôler la structure tridimensionnelle de l'élément de liaison réalisé et notamment la géométrie et la distribution des premières portions de matériau, c'est-à-dire des IMC, dans l'élément de liaison. Les deux parois métalliques peuvent être réalisées telles que les premières portions de matériau comportant les IMC forment des « couches » perpendiculaires aux faces solidarisées des objets. Ainsi, les premières portions de matériau comportant les IMC n'affectent pas la tenue mécanique de l'élément de liaison. Ce contrôle permet également de maîtriser les dimensions finales de l'élément de liaison, mais également la nature des interfaces (entre la seconde portion de matériau et les objets) qui vont assurer la tenue mécanique de l'assemblage.

Les deux parois métalliques peuvent être en contact avec les deux objets. Ainsi, ces deux parois métalliques peuvent servir également de cales d'épaisseur entre les deux objets afin de garantir l'espacement entre les deux objets, et donc l'épaisseur de l'élément de liaison réalisé.

Dans un deuxième et un troisième mode de réalisation, l'assemblage peut comporter une ou plusieurs premières portions de matériau comprenant les composés intermétalliques, les premières portions de matériau pouvant être en contact avec l'un des deux objets et recouvertes par la seconde portion de matériau.

Dans ce cas, l'assemblage peut comporter en outre une ou plusieurs portions métalliques, ou plots métalliques, à base du deuxième métal et en contact avec l'un des deux objets, chacun des plots métalliques étant recouvert au moins partiellement par l'une des premières portions de matériau. Là encore, les plots ou portions métalliques, qui peuvent avoir une géométrie définie en fonction de la géométrie souhaitée des premières portions de matériau au sein de l'élément de liaison, peuvent donc contrôler la structure tridimensionnelle de l'élément de liaison et notamment la géométrie et la distribution des IMC dans l'élément de liaison. Les plots métalliques peuvent être réalisés tels que les premières portions de matériau comportant les IMC forment des plots discontinus contre au moins l'un des deux objets le long de l'élément de liaison. Ainsi, les portions de matériau comportant les IMC n'affectent pas la tenue mécanique de l'élément de liaison. Ce contrôle permet également de maîtriser les dimensions finales de l'élément de liaison, mais également la nature des interfaces qui vont assurer la tenue mécanique de l'assemblage. Il est également possible de réaliser ces plots de manière continue le long de l'élément de liaison.

Le premier métal de brasage peut comporter de l'étain, et/ou le deuxième métal peut comporter du nickel ou du cuivre, et/ou le troisième métal peut comporter de l'or. Il est ainsi possible de réaliser l'élément de liaison à partir d'un eutectique de type Au-Sn, par exemple du type Au-Sn 29% at. (c'est-à-dire un alliage formé de 29% atomique d'étain et de 71% atomique d'or), qui a un point de fusion compatible avec une encapsulation de microsystèmes. De plus, un tel eutectique a également pour avantage de ne pas nécessiter de décapage ou de désoxydation avant le brasage contrairement à d'autres métaux ou eutectiques de brasage fondant à basses températures (et donc compatibles pour encapsuler des microsystèmes) qui sont généralement sensibles à l'oxydation. Dans une variante, il est possible d'utiliser l'eutectique Au-Si 19% at.

Le deuxième métal comportant du cuivre ou du nickel permet d'augmenter le point de fusion de l'élément de liaison en formant des IMC issus de la réaction chimique avec l'étain. De plus, le cuivre et le nickel ont également pour avantage de pouvoir être déposés de manière électrolytique ou par un dépôt PVD (dépôt physique en phase Vapeur).

Avantageusement, le troisième métal est différent du premier métal de brasage. Toutefois, l'invention peut s'appliquer à un assemblage dans lequel le troisième métal est de même nature que le premier métal de brasage.

Les deux objets peuvent être un substrat et un capot, l'assemblage pouvant comporter en outre au moins un microsystème solidarisé au substrat et encapsulé dans une cavité formée entre le substrat et le capot, l'élément de liaison étant un cordon de scellement formant des parois latérales hermétiques de la cavité. Un tel assemblage permet notamment de réaliser une encapsulation sous atmosphère contrôlée du microsystème.

L'invention concerne également un procédé d'assemblage de deux objets, comportant au moins les étapes de :
- réalisation d'un élément de brasage formé d'au moins un premier métal de brasage et d'un troisième métal sur l'un des deux objets,
- mise en contact de l'élément de brasage avec au moins un deuxième métal dont le point de fusion est supérieur à celui du premier métal de brasage,
- brasage des deux objets par solidification isotherme de l'élément de brasage, formant au moins un élément de liaison disposé entre les deux objets, ledit élément de liaison comportant au moins une première portion de matériau comprenant des composés intermétalliques d'une phase formée du premier métal de brasage et du deuxième métal, et au moins une seconde portion de matériau composée du troisième métal, ladite seconde portion de matériau étant en contact avec les deux objets.

La mise en oeuvre d'un tel procédé permet donc de garantir :
- un contrôle de la solidification localisée des métaux utilisés pour le brasage, notamment autour des microsystèmes lorsque le procédé d'assemblage réalise une encapsulation de microsystèmes, et
- un contrôle de l'espace formé entre les deux objets assemblés.

Selon le premier mode de réalisation, le procédé d'assemblage peut comporter en outre, avant l'étape de mise en contact de l'élément de brasage avec le deuxième métal, une étape de réalisation d'au moins deux parois métalliques à base du deuxième métal en contact avec au moins l'un des deux objets, et dans lequel :
- lors de l'étape de mise en contact de l'élément de brasage avec le deuxième métal, l'élément de brasage peut être disposé entre lesdites deux parois métalliques, et
- l'étape de brasage peut former au moins deux premières portions de matériau comprenant les composés intermétalliques, les deux premières portions de matériau pouvant être en contact avec les deux objets, la seconde portion de matériau pouvant être disposée entre les deux premières portions de matériau, et chacune des deux premières portions de matériau pouvant être disposée entre la seconde portion de matériau et l'une des deux parois métalliques.

Selon le deuxième mode de réalisation, le procédé d'assemblage peut comporter en outre, avant l'étape de réalisation de l'élément de brasage, une étape de réalisation d'un ou plusieurs plots métalliques à base du deuxième métal en contact avec ledit un des deux objets, l'élément de brasage pouvant être réalisé tel qu'il recouvre au moins partiellement les plots métalliques, et dans lequel l'étape de brasage peut former une ou plusieurs premières portions de matériau comprenant les composés intermétalliques, les premières portions de matériau pouvant recouvrir au moins partiellement les plots métalliques et pouvant être recouvertes par la seconde portion de matériau.

Selon le troisième mode de réalisation, le procédé d'assemblage peut comporter en outre, avant l'étape de réalisation de l'élément de brasage, une étape de réalisation d'un ou plusieurs plots métalliques à base du deuxième métal en contact avec l'un des deux objets, l'élément de brasage pouvant être réalisé sur l'autre des deux objets, et dans lequel :
- lors de l'étape de mise en contact de l'élément de brasage avec le deuxième métal, l'élément de brasage peut être disposé contre les plots métalliques, et
- l'étape de brasage peut former une ou plusieurs premières portions de matériau comprenant les composés intermétalliques, les premières portions de matériau pouvant recouvrir au moins partiellement les plots métalliques et pouvant être recouvertes par la seconde portion de matériau.

La réalisation de l'élément de brasage peut comporter la mise en oeuvre des étapes suivantes :
- dépôt du troisième métal sur un des deux objets,
- dépôt du premier métal de brasage sur le troisième métal,
- traitement thermique du premier métal de brasage et du troisième métal, pouvant former par diffusion à l'état solide l'élément de brasage qui peut être à base d'un eutectique composé du premier métal de brasage et du troisième métal.

Les deux objets peuvent être un substrat et un capot, au moins un microsystème pouvant être solidarisé au substrat, l'élément de brasage pouvant être réalisé sous la forme d'un cordon tel que l'étape de brasage forme un cordon de scellement reliant mécaniquement le capot au substrat et formant des parois latérales hermétiques d'une cavité formée entre le substrat et le capot et dans laquelle le microsystème peut être encapsulé.

L'invention s'applique particulièrement à un assemblage réalisant une encapsulation d'un microsystème dans une cavité formée entre un support et un capot, par exemple sous vide ou sous atmosphère contrôlée. L'invention peut également s'appliquer à un assemblage de pièces par exemple métalliques ou à base de métal et de céramiques, en formant une cale d'épaisseur contrôlée entre les deux objets, avec une localisation des intermétalliques telle que définie précédemment, notamment pour des applications aéronautiques ou aérospatiales.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une vue en coupe d'un assemblage de deux objets selon la présente invention,
- les figures 2 à 4 représentent des étapes d'un procédé d'assemblage, objet de la présente invention, selon un premier mode de réalisation,
- les figures 5 à 7 représentent des étapes d'un procédé d'assemblage, objet de la présente invention, selon un deuxième mode de réalisation,
- la figure 8 représente une étape d'un procédé d'assemblage, objet de la présente invention, selon une variante du second mode de réalisation,
- les figures 9 et 10 représentent des étapes d'un procédé d'assemblage, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

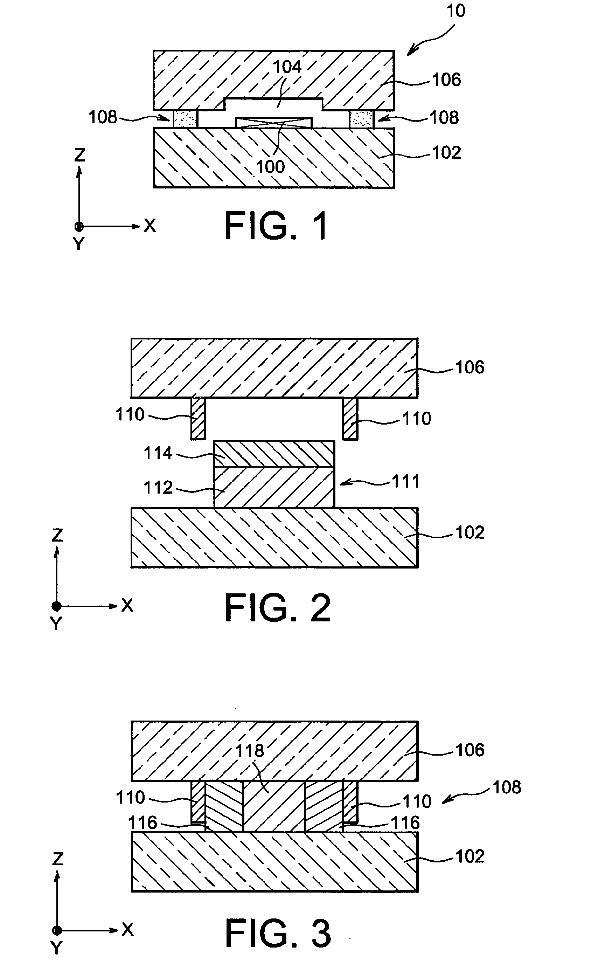

Un assemblage 10 de deux objets 102 et 106, réalisant ici une encapsulation d'un microsystème 100, par exemple un dispositif MEMS, NEMS ou MOEMS, dans une cavité 104 formée entre un substrat 102 sur lequel est réalisé le microsystème 100 et un capot 106 est représenté sur la figure 1. Le substrat 102 et le capot 106 sont à base d'un ou plusieurs matériaux permettant de les solidariser l'un à l'autre par un procédé de brasage. Ainsi, le substrat 102 est à base d'un semi-conducteur tel que du silicium, tandis que le capot 106 est formé par un second substrat également à base de semi-conducteur tel que du silicium. La cavité 104 est délimitée latéralement par un cordon de scellement 108 formant un élément de liaison assurant la solidarisation du capot 106 au substrat 102. Le matériau du cordon de scellement 108 assure également une encapsulation hermétique du microsystème 100. Ainsi, le microsystème 100 peut être encapsulé dans une atmosphère particulière gazeuse ou sous vide.

On se réfère aux figures 2 à 4 qui illustrent les étapes d'un procédé d'assemblage du capot 106 au substrat 102, formant l'assemblage 10, selon un premier mode de réalisation.

Pour réaliser un tel assemblage 10, on forme tout d'abord, tel que représenté sur la figure 2, sur une face du capot 106 destinée à être disposée en regard du substrat 102, des portions métalliques 110, formant des parois métalliques, destinées à délimiter latéralement de manière continue, c'est-à-dire tout autour de la cavité 104, le cordon de scellement 108, et à former des composants intermétalliques au sein du cordon de scellement 108. Ces parois métalliques 110 sont par exemple à base de nickel afin que par la suite, un eutectique notamment à base d'un métal de brasage et en contact avec ces parois 110 forme, grâce à la mise en oeuvre d'un procédé de brasage par solidification isotherme, des composés intermétalliques (IMC) d'une phase formée de nickel et du métal de brasage. Il est également possible que les parois métalliques 110 soient à base de cuivre.

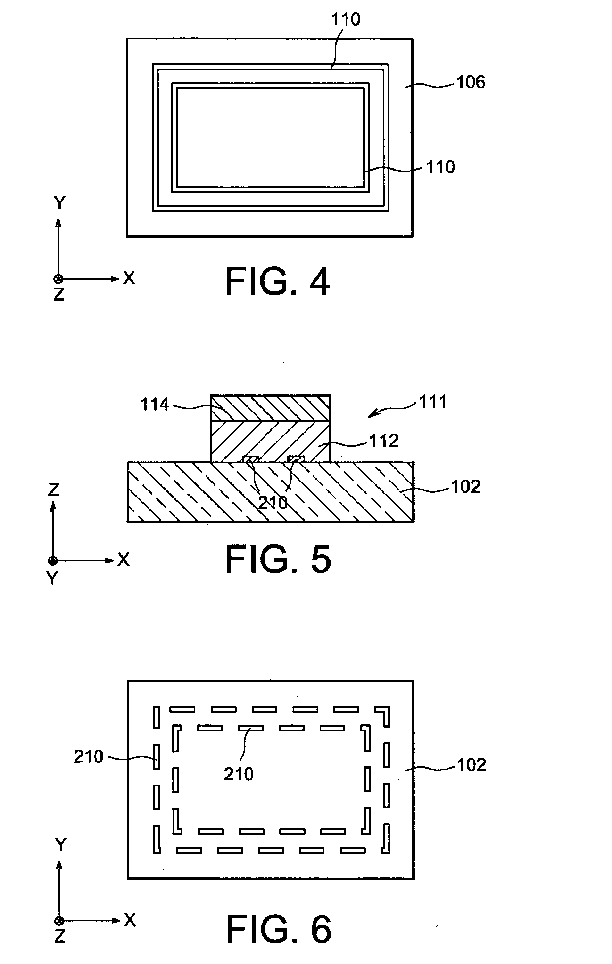

L'épaisseur des parois métalliques 110 (dimension selon l'axe Z représenté sur la figure 2), c'est-à-dire la dimension perpendiculaire aux plans des faces principales du substrat 102 (le microsystème 100 étant disposé sur l'une de ces faces principales) et du capot 106 des parois métalliques 110, est ici inférieure à la hauteur du cordon de scellement 108 destiné à être réalisé, et par exemple comprise entre environ 1 µm et 4 µm. La figure 4 représente une vue de dessous du capot 106 au niveau duquel sont réalisées les parois 110. Le motif formé par les portions métalliques dans le plan (X, Y) correspond au motif souhaité du cordon de scellement 108.

Parallèlement à la réalisation des parois métalliques 110, un élément de brasage 111 est formé sur le substrat 102 sous la forme d'un cordon. Ce cordon de brasage 111 est ici composé d'une première couche 114 à base d'un métal de brasage, par exemple de l'étain, disposée sur une seconde couche 112 à base d'un autre métal, par exemple de l'or.

On décrit ci-dessous un exemple de réalisation de ce cordon de brasage 111. On réalise tout d'abord une oxydation thermique de la face du substrat 102 sur laquelle le cordon de brasage 111 est destiné à être réalisé, formant une fine couche d'oxyde, d'épaisseur par exemple comprise entre quelques dizaines de nanomètres et quelques centaines de nanomètres, au niveau de cette face du substrat 102. On réalise ensuite, sur cette couche d'oxyde, un dépôt PVD d'une couche d'accroche, par exemple à base de titane, puis d'une couche barrière, par exemple à base de nitrure de tungstène ou de titane et d'épaisseur égale à environ quelques dizaines de nanomètres ou par exemple comprise entre environ 10 nm et 100 nm. Le matériau de la couche barrière est choisi tel qu'il ne soit pas ou peu réactif avec le métal de brasage 114 et l'autre métal 112, c'est-à-dire tel qu'il ne réagisse pas chimiquement lors d'un brasage avec les métaux 112 et 114 afin d'éviter la formation d'IMC. Une couche d'électrolyse, à base dudit autre métal (ici de l'or) est ensuite déposée par PVD sur la couche barrière, avantageusement dans le même équipement de dépôt PVD que celui utilisé pour déposer la couche barrière. L'épaisseur de la couche d'électrolyse est par exemple égale à environ 100 nm.

On réalise ensuite, sur la couche d'électrolyse précédemment déposée, un masque dont le motif (dans le plan (X, Y) représenté sur la figure 2) associé à celui des parois métalliques 110 correspond à celui du cordon de brasage 111 que l'on souhaite réaliser. Une photolithographie de la couche d'électrolyse est ensuite réalisée à travers ce masque.

On réalise alors un premier dépôt électrolytique d'or, formant la seconde couche 112 qui a par exemple une épaisseur égale à environ 3 µm, puis un second dépôt électrolytique d'étain, formant la première couche 114 qui a par exemple une épaisseur égale à environ 2 µm. Les épaisseurs des couches 112 et 114 sont choisies en fonction de l'épaisseur souhaitée du cordon de brasage 111, qui correspondra sensiblement à la somme des épaisseurs des couches 112 et 114 (ici égale à environ 5 µm), et en fonction de la composition souhaitée du cordon de brasage 111. Le masque ainsi que les portions de la couche d'électrolyse, de la couche barrière, de la couche d'accroche et de la couche d'oxyde ne se trouvant pas sous les couches métalliques 112 et 114 sont ensuite retirés, par exemple par gravure.

On réalise ensuite un traitement thermique sous vide du substrat 102 afin que les métaux du cordon de brasage 111 forment, par diffusion à l'état solide entre les deux couches 112 et 114, un eutectique Au/Sn. Dans le cas présent, compte tenu des épaisseurs des couches 112 et 114 dont le ratio est égal à environ 1,5, on obtient donc un eutectique de type Au - Sn 29% at.

Les parois métalliques 110 sont réalisées sur le capot 106 par dépôt électrolytique ou par dépôt PVD. Les étapes mises en oeuvre pour réaliser les parois métalliques 110 peuvent être sensiblement similaires à celles formant le cordon de brasage 111 (oxydation thermique du capot 106, dépôts d'une couche d'accroche, d'une couche barrière et d'une couche d'électrolyse, réalisation d'un masque, photolithographie, dépôt électrolytique de nickel, et retrait du masque et des portions des couches précédemment réalisées ne se trouvant pas sous les parois métalliques 110). La largeur (dimension selon l'axe X) des parois métalliques 110 est choisie telle que le volume de ces parois métalliques 110 soit compris entre environ 5% et 20% du volume du cordon de brasage 111.

On met ensuite en oeuvre un brasage par solidification isotherme afin de solidariser le capot 106 au substrat 102 et réaliser ainsi l'encapsulation du microsystème 100 dans la cavité 104. Pour cela, le cordon de brasage 111 est mis en contact avec le capot 106 tel que ce cordon 111 se retrouve disposé entre les deux parois métalliques 110. Lors du brasage ensuite réalisé, l'eutectique du cordon 111 fond tout en étant en contact avec les parois métalliques 110, formant ainsi, contre les parois métalliques 110, des portions de matériau 116 comportant des IMC. Ces IMC sont composés d'une phase (Ni, Sn) provenant de la réaction de l'étain du cordon 111 avec le nickel des parois métalliques 110. Entre ces premières portions de matériau 116, une seconde portion de matériau 118, composée du matériau restant de l'eutectique qui n'a pas réagi avec les parois métalliques 110, est formée entre les premières portions 116 (voir figure 3). Cette seconde portion de matériau 118 est ici formée d'une phase (Au, Sn) riche en or étant donné que l'étain de l'eutectique du cordon 111 est totalement ou en grande partie consommée pour la formation des premières portions 116 comportant les IMC. L'or et le nickel définissent une solution solide sur l'ensemble du diagramme de phase binaire qui les concerne. Dans les phases (Ni, Sn) on pourra donc trouver de l'or en substitution du nickel et réciproquement pour les phases (Au, Sn).

Ainsi, lors du brasage, les parois métalliques 110 contrôlent la structure issue de la solidification (cordon de scellement 108), et notamment la géométrie et la distribution des IMC 116 au sein du cordon de scellement 108. Dans ce premier mode de réalisation, les parois métalliques 110 forment des murs verticaux contre lesquels les IMC 116 précipitent sous forme de couches perpendiculaires au substrat 102 et au capot 106. Une partie du cordon de scellement 108 autre que les IMC, à savoir la seconde portion de matériau 118, assure une liaison mécanique forte entre le substrat 102 et le capot 106. Ainsi, la présence d'IMC au sein du cordon de scellement 108 n'affecte pas la tenue mécanique entre le substrat 102 et le capot 106 obtenue par le cordon de scellement 108.

Dans une variante du premier mode de réalisation précédemment décrit, il est possible de réaliser les parois métalliques 110 telles que leur épaisseur soit sensiblement égale à l'épaisseur souhaitée du cordon de scellement 108. Ainsi, les parois métalliques 110 peuvent jouer le rôle de cales d'épaisseur entre le capot 106 et le substrat 102, et garantir ainsi l'épaisseur de cordon de scellement 108 réalisé.

Dans le mode de réalisation décrit ici, et comme représenté sur la figure 4, les parois métalliques 110 sont réalisées de manière continue le long du motif du cordon de scellement 108. Dans une variante, il est possible que les parois métalliques 110 soient réalisées sous la forme de portions discontinues.

On se réfère maintenant aux figures 5 à 7 qui illustrent les étapes d'un procédé d'assemblage du capot 106 au substrat 102 par l'intermédiaire d'un cordon de scellement 208, formant l'assemblage 10, selon un second mode de réalisation. Dans ce second mode de réalisation, cet assemblage 10 permet d'encapsuler le microsystème 100 dans la cavité 104 formée entre le substrat 102 et le capot 106 et délimitée latéralement par le cordon de scellement 208.

Contrairement au premier mode de réalisation, les portions métalliques destinées à réagir chimiquement avec le métal de brasage pour former des IMC ne sont pas réalisées sous la forme de portions continues verticales contre le capot 106, c'est-à-dire de parois métalliques. Dans ce second mode de réalisation, on réalise, préalablement à la réalisation du cordon de brasage 111, une pluralité de portions métalliques 210, sous la forme de plots métalliques, sur la face du substrat 102 destinée à être en regard du capot 106, sous la forme de portions discontinues. Le motif formé par ces plots métalliques 210 correspond au motif du cordon de scellement 208 que l'on souhaite réaliser (voir la figure 6 correspondant à une vue de dessus du substrat 102 sur lequel les plots métalliques 210 sont réalisés). L'épaisseur (dimension selon l'axe Z représenté sur la figure 5) des plots métalliques 210 peut être égale à quelques centaines de nanomètres, ou par exemple comprise entre environ 100 nm et 1 µm. Les étapes mises en oeuvre pour réaliser ces plots métalliques 210 peuvent être sensiblement similaires à celles mises en oeuvre pour réaliser les parois métalliques 110, excepté que le motif discontinu des plots 210 est préalablement défini par photolithographie et gravure à travers un masque dans la couche d'électrolyse initialement déposée par PVD sur la couche barrière.

Les couches métalliques 112 et 114 formant le cordon de brasage 111 sont ensuite déposées sur le substrat 102 de manière analogue au premier mode de réalisation, excepté que le cordon de brasage 111 recouvre les plots métalliques 210. Là encore, les étapes mises en oeuvre pour réaliser ce cordon de brasage 111 peuvent être sensiblement similaires à celles mises en oeuvre dans le premier mode de réalisation (dépôt des différentes couches, photolithographie pour dimensionner le cordon 111, dépôt électrolytique des couches 112 et 114, retrait des différents éléments précédemment réalisés ne se trouvant pas sous les couches 112 et 114, traitement thermique formant l'eutectique composé des métaux des couches 112 et 114).

Le cordon de scellement 208 est ensuite formé en mettant en contact le capot 106 avec le cordon de brasage 111 et en réalisant un brasage par solidification isotherme afin que l'eutectique fondu du cordon 111, et plus particulièrement les éléments provenant du métal de brasage, réagisse chimiquement avec le métal des plots métalliques 210, formant des portions de matériau 216 comportant des IMC, ces portions recouvrant les plots métalliques 210. Les plots métalliques 210 servent également de barrière à l'écoulement à l'écoulement du métal fondu du cordon 111 . Le métal restant n'ayant pas réagi avec les plots métalliques 210 forme une seconde portion de matériau 218 recouvrant les portions de matériau 216 ainsi qu'une partie du substrat 102 se trouvant à côté des portions de matériau 216 afin d'assurer un fort maintien mécanique entre le substrat 102 et le capot 106. Le cordon de scellement 208 obtenu peut être vu comme comportant des ancrages mécaniques formés par les portions de matériau 216 comportant les IMC, consolidés par une matrice métallique riche en or formée par la seconde portion de matériau 218.

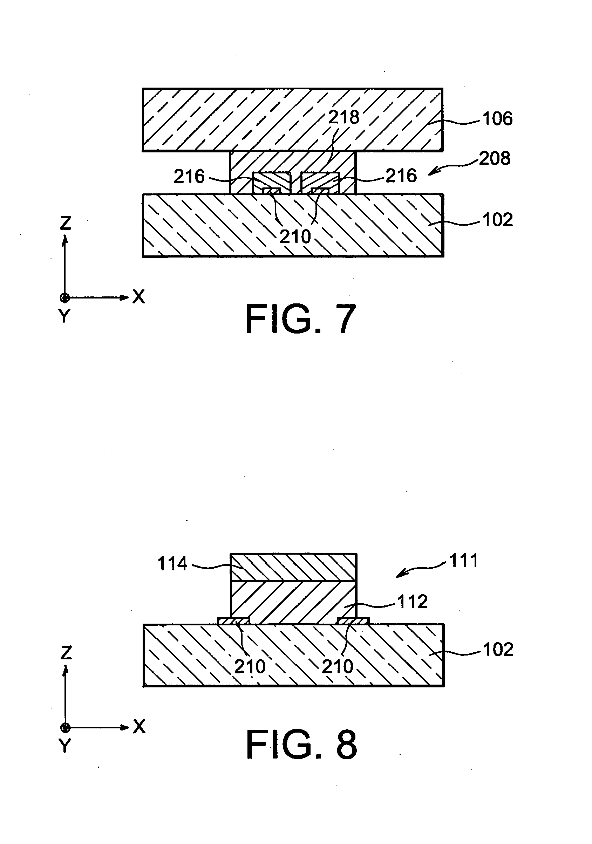

Dans une première variante de ce second mode de réalisation, il est possible que les plots métalliques 210 et le cordon de brasage 111 soient réalisés tels que le cordon de brasage 111 ne recouvre que partiellement les plots métalliques 210 (voir figure 8). Ainsi, on obtient un cordon de scellement comportant des portions de matériau d'IMC formées en périphérie du cordon de scellement. Dans ce cas, la solidification isotherme commencera à l'aplomb des plots métalliques 210, limitant ainsi l'écoulement de la brasure. De plus, la liaison mécanique entre le substrat et le capot est dans ce cas assurée majoritairement par la seconde portion de métal par exemple enrichie en or.

Dans une seconde variante de ce second mode de réalisation, les plots métalliques 210 peuvent être continues, c'est-à-dire ininterrompus, le long de l'ensemble du cordon formé. Le motif ainsi formé par les portions métalliques 210 correspond sensiblement au motif représenté sur la figure 4.

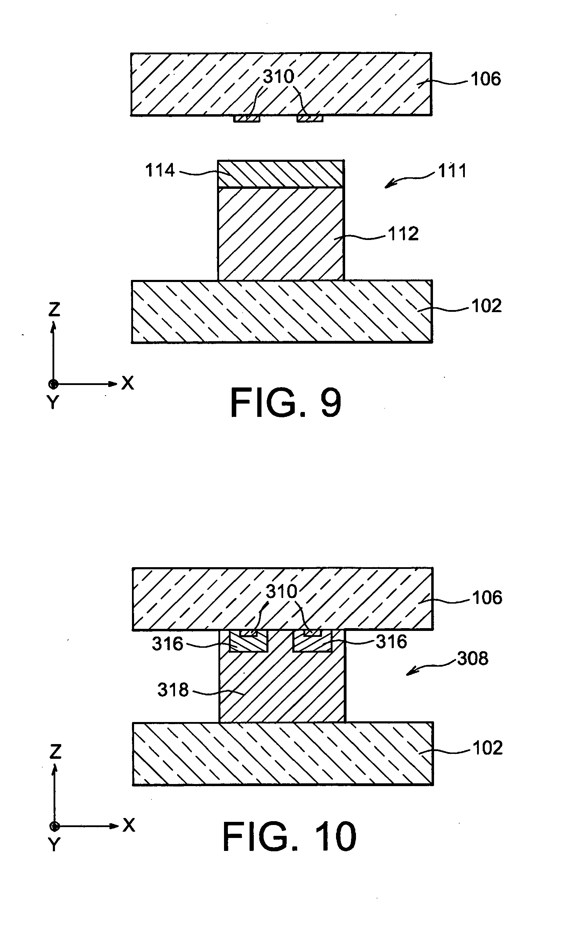

On se réfère maintenant aux figures 9 et 10 pour décrire un procédé d'assemblage du capot 106 au substrat 102 par l'intermédiaire d'un cordon de scellement 308 selon un troisième mode de réalisation.

Par rapport à l'assemblage selon le second mode de réalisation précédemment décrit en liaison avec les figures 5 à 7, des portions métalliques 310, formant des plots métalliques, sont réalisées contre le capot 106 et non contre le substrat 102. Le motif, les dimensions et la nature des plots métalliques 310 sont par exemple similaires à celles des plots métalliques 210. Le cordon de brasage 111 est réalisé contre le substrat 102 de manière analogue au premier mode de réalisation.

L'assemblage est ensuite réalisé en mettant en contact le cordon 111 avec les plots métalliques 310 puis en mettant en oeuvre un brasage par solidification isotherme, formant des portions de matériaux 316 comportant des IMC et recouvrant les plots métalliques 310, de manière sensiblement analogues aux portions de matériau 216 précédemment décrites. Le métal restant du cordon 111 qui n'a pas réagi avec les plots métalliques 310 forme une seconde portion de matériau 318 entourant les portions de matériau 316 et qui, grâce au contact avec le capot 106, à côté des portions de matériau 316, et le substrat 102, assure un fort maintien mécanique entre le substrat 102 et le capot 106. On évite ainsi toute réaction de diffusion entre les métaux des plots 310 et le cordon 111 lors du traitement thermique d'homogénéisation du métal de brasage lorsque celui-ci est un alliage eutectique.

Les variantes du second mode de réalisation précédemment décrites, dans lesquelles le cordon de brasage ne recouvre que partiellement les portions métalliques et/ou les portions métalliques sont continues, peuvent également s'appliquer au troisième mode de réalisation décrit ci-dessus.

Les assemblages précédemment décrits selon les différents modes de réalisation sont avantageusement mis en oeuvre pour réaliser une encapsulation collective de plusieurs microsystèmes dans plusieurs cavités distinctes formées entre le capot et le support. On réalisera avantageusement un ou plusieurs cordons de scellement, par exemple similaires à l'un des cordons de scellement 108, 208 ou 308, en périphérie des substrats formant le support et le capot, afin d'assurer une étanchéité entre ces substrats, entre les cavités, mais également pour renforcer la tenue mécanique de l'assemblage de ces deux substrats. Il est ainsi possible de mettre en oeuvre des étapes technologiques post-assemblage telles qu'un amincissement et un polissage d'un des deux substrats, suivi par exemple d'une découpe des substrats ou de d'autres étapes classiques de la microélectronique.

## Revendications

1. Assemblage (10) de deux objets (102, 106) solidarisés l'un à l'autre par au moins un élément de liaison (108, 208, 308) disposé entre les deux objets (102, 106), ledit élément de liaison (108, 208, 308) comportant au moins une première portion de matériau (116, 216, 316) comprenant des composés intermétalliques d'une phase formée d'un premier métal de brasage et d'un deuxième métal dont le point de fusion est supérieur à celui du premier métal de brasage, **caractérisé en ce que** ledit élément de liaison (108, 208, 308) comportant en outre au moins une seconde portion de matériau (118, 218, 318), distincte de la première portion de matériau (116, 216, 316) et composée d'au moins un troisième métal, ladite seconde portion de matériau (118, 218, 318) étant en contact avec les deux objets (102, 106).

2. Assemblage (10) selon la revendication 1, comportant au moins deux premières portions de matériau (116) comprenant les composés intermétalliques, les deux premières portions de matériau (116) étant en contact avec les deux objets (102, 106), la seconde portion de matériau (118) étant disposée entre les deux premières portions de matériau (116).

3. Assemblage (10) selon la revendication 2, comportant en outre au moins deux parois métalliques (110) à base du deuxième métal et en contact avec au moins l'un (106) des deux objets, chacune des deux premières portions de matériau (116) étant disposée entre la seconde portion de matériau (118) et l'une des deux parois métalliques (110).

4. Assemblage (10) selon la revendication 3, dans lequel les deux parois métalliques (110) sont en contact avec les deux objets (102, 106).

5. Assemblage (10) selon la revendication 1, comportant une ou plusieurs premières portions de matériau (216, 316) comprenant les composés intermétalliques, les premières portions de matériau (216, 316) étant en contact avec l'un des deux objets (102, 106) et recouvertes par la seconde portion de matériau (218, 318).

6. Assemblage (10) selon la revendication 5, comportant en outre un ou plusieurs plots métalliques (210, 310) à base du deuxième métal et en contact avec l'un des deux objets (102, 106), chacun des plots métalliques (210, 310) étant recouvert au moins partiellement par l'une des premières portions de matériau (216, 316).

7. Assemblage (10) selon l'une des revendications précédentes, dans lequel le premier métal de brasage comporte de l'étain, et/ou le deuxième métal comporte du nickel ou du cuivre, et/ou le troisième métal comporte de l'or.

8. Assemblage (10) selon l'une des revendications précédentes, dans lequel les deux objets sont un substrat (102) et un capot (106), l'assemblage (10) comportant en outre au moins un microsystème (100) solidarisé au substrat (102) et encapsulé dans une cavité (104) formée entre le substrat (102) et le capot (106), l'élément de liaison (108, 208, 308) étant un cordon de scellement formant des parois latérales hermétiques de la cavité (104).

9. Procédé d'assemblage de deux objets (102, 106), comportant au moins les étapes de :
- réalisation d'un élément de brasage (111) formé d'au moins un premier métal de brasage (114) et d'un troisième métal (112) sur l'un (102) des deux objets,
- mise en contact de l'élément de brasage (111) avec au moins un deuxième métal (110, 210, 310) dont le point de fusion est supérieur à celui du premier métal de brasage (114),
- brasage des deux objets (102, 106) par solidification isotherme de l'élément de brasage (111), formant au moins un élément de liaison (108, 208, 308) disposé entre les deux objets (102, 106), ledit élément de liaison (108, 208, 308) comportant au moins une première portion de matériau (116, 216, 316) comprenant des composés intermétalliques d'une phase formée du premier métal de brasage et du deuxième métal, et **caractérisé en ce que** ledit élément de liaison comporte au moins une seconde portion de matériau (118, 218, 318), distincte de la première portion de matériau (116, 216, 316) et composée du troisième métal, ladite seconde portion de matériau (118, 218, 318) étant en contact avec les deux objets (102, 106).

10. Procédé d'assemblage selon la revendication 9, comportant en outre, avant l'étape de mise en contact de l'élément de brasage (111) avec le deuxième métal (110), une étape de réalisation d'au moins deux parois métalliques (110) à base du deuxième métal en contact avec au moins l'un (106) des deux objets, et dans lequel :
- lors de l'étape de mise en contact de l'élément de brasage (111) avec le deuxième métal (110), l'élément de brasage (111) est disposé entre lesdites deux parois métalliques (110), et
- l'étape de brasage forme au moins deux premières portions de matériau (116) comprenant les composés intermétalliques, les deux premières portions de matériau (116) étant en contact avec les deux objets (102, 106), la seconde portion de matériau (118) étant disposée entre les deux premières portions de matériau (116), et chacune des deux premières portions de matériau (116) étant disposée entre la seconde portion de matériau (118) et l' une des deux parois métalliques (110).

11. Procédé d'assemblage selon la revendication 9, comportant en outre, avant l'étape de réalisation de l'élément de brasage (111), une étape de réalisation d'un ou plusieurs plots métalliques (210) à base du deuxième métal en contact avec ledit un (102) des deux objets, l'élément de brasage (111) étant réalisé tel qu'il recouvre au moins partiellement les plots métalliques (210), et dans lequel l'étape de brasage forme une ou plusieurs premières portions de matériau (216) comprenant les composés intermétalliques, les premières portions de matériau (216) recouvrant au moins partiellement les plots métalliques (210) et étant recouvertes par la seconde portion de matériau (218).

12. Procédé d'assemblage selon la revendication 9, comportant en outre, avant l'étape de réalisation de l'élément de brasage (111), une étape de réalisation d'un ou plusieurs plots métalliques (310) à base du deuxième métal en contact avec l'un (106) des deux objets, l'élément de brasage (111) étant réalisé sur l'autre (102) des deux objets, et dans lequel :
- lors de l'étape de mise en contact de l'élément de brasage (111) avec le deuxième métal (110), l'élément de brasage (111) est disposé contre les plots métalliques (310), et
- l'étape de brasage forme une ou plusieurs premières portions de matériau (316) comprenant les composés intermétalliques, les premières portions de matériau (316) recouvrant au moins partiellement les plots métalliques (310) et étant recouvertes par la seconde portion de matériau (318).

13. Procédé d'assemblage selon l'une des revendications 9 à 12, dans lequel la réalisation de l'élément de brasage (111) comporte la mise en oeuvre des étapes suivantes :
- dépôt du troisième métal (112) sur un (102) des deux objets,
- dépôt du premier métal de brasage (114) sur le troisième métal (112),
- traitement thermique du premier métal de brasage (114) et du troisième métal (112), formant par diffusion à l'état solide l'élément de brasage (111) qui est à base d'un eutectique composé du premier métal de brasage et du troisième métal.

14. Procédé d'assemblage selon l'une des revendications 9 à 13, dans lequel le premier métal de brasage comporte de l'étain, et/ou le deuxième métal comporte du nickel ou du cuivre, et/ou le troisième métal comporte de l'or.

15. Procédé d'assemblage selon l'une des revendications 9 à 14, dans lequel les deux objets sont un substrat (102) et un capot (106), au moins un microsystème (100) étant solidarisé au substrat (102), l'élément de brasage (111) étant réalisé sous la forme d'un cordon tel que l'étape de brasage forme un cordon de scellement (108, 208, 308) reliant mécaniquement le capot (106) au substrat (102) et formant des parois latérales hermétiques d'une cavité (104) formée entre le substrat (102) et le capot (106) et dans laquelle le microsystème (100) est encapsulé.

## Patentansprüche

1. Verbund (10) von zwei Objekten (102, 106), welche durch mindestens ein zwischen den zwei Objekten (102, 106) angeordnetes Verbindungselement (108, 208, 308) miteinander verbunden sind, wobei das Verbindungselement (108, 208, 308) zumindest einen ersten Materialabschnitt (116, 216, 316) aufweist, welcher intermetallische Verbindungen einer Phase gebildet aus einem ersten Lötmetall und einem zweiten Metall aufweist, welches einen Schmelzpunkt höher als der des ersten Lötmetalls aufweist, **dadurch gekennzeichnet, dass** das Verbindungselement (108, 208, 308) des Weiteren zumindest einen zweiten Materialabschnitt (118, 218, 318) aufweist, welcher sich von dem ersten Materialabschnitt (116, 216, 316) unterscheidet und sich aus mindestens einem dritten Metall zusammensetzt, wobei der zweite Materialabschnitt (118, 218, 318) in Kontakt mit den zwei Objekten (102, 106) ist.

2. Verbund (10) nach Anspruch 1, welcher zumindest zwei die intermetallischen Verbindungen umfassende erste Materialabschnitte (116) aufweist, wobei die zwei ersten Materialabschnitte (116) in Kontakt mit den zwei Objekten (102, 106) sind, und wobei der zweite Materialabschnitt (118) zwischen den zwei ersten Materialabschnitten (116) angeordnet ist.

3. Verbund (10) nach Anspruch 2, welcher des Weiteren zumindest zwei metallische Wände (110) auf Basis des zweiten Metalls und in Kontakt mit mindestens einem (106) der zwei Objekte aufweist, wobei jeder der zwei ersten Materialabschnitte (116) zwischen dem zweiten Materialabschnitt (118) und einer der zwei metallischen Wände (110) angeordnet ist.

4. Verbund (10) nach Anspruch 3, in welchem die zwei metallischen Wände (110) in Kontakt mit den zwei Objekten (102, 106) sind.

5. Verbund (10) nach Anspruch 1, welcher einen oder mehrere die intermetallischen Verbindungen umfassende erste Materialabschnitte (216, 316) aufweist, wobei die ersten Materialabschnitte (216, 316) in Kontakt mit einem der zwei Objekte (102, 106) sind und von dem zweiten Materialabschnitt (218, 318) überdeckt sind.

6. Verbund (10) nach Anspruch 5, welcher des Weiteren einen oder mehrere metallische Lötstützpunkte oder Kontakte (210, 310) auf Basis des zweiten Metalls und in Kontakt mit einem der zwei Objekte (102, 106) aufweist, wobei jeder der metallischen Lötstützpunkte bzw. Kontakte (210, 310) zumindest teilweise von einem der ersten Materialabschnitte (216, 316) überdeckt ist.

7. Verbund (10) nach einem der vorhergehenden Ansprüche, in welchem das erste Lötmetall Zinn aufweist, und/oder das zweite Metall Nickel oder Kupfer aufweist, und/oder das dritte Metall Gold aufweist.

8. Verbund (10) nach einem der vorhergehenden Ansprüche, in welchem die zwei Objekte ein Substrat (102) und eine Abdeckung (106) sind, wobei der Verbund (10) darüber hinaus zumindest ein Mikrosystem (100) aufweist, welches mit dem Substrat (102) verbunden ist und in einem zwischen dem Substrat (102) und der Abdeckung (106) gebildeten Hohlraum (104) eingekapselt ist, wobei das Verbindungselement (108, 208, 308) eine Versiegelungsnaht bzw. Dichtungswulst ist, welche die hermetisch dichten Seitenwände des Hohlraums (104) bildet.

9. Verfahren zum Verbinden von zwei Objekten (102, 106), welches zumindest die folgenden Schritte umfasst:
- Realisierung eines Lötelements (111), welches aus zumindest einem ersten Lötmetall (114) und einem dritten Metall (112) auf dem einem (102) der zwei Objekte ausgebildet ist;
- Inkontaktbringung des Lötelements (111) mit mindestens einem zweiten Metall (110, 210, 310), dessen Schmelzpunkt höher ist als der des ersten Lötmetalls (114);
- Löten der zwei Gegenstände (102, 106) durch isotherme Erstarrung des Lötelements (111), wodurch zumindest ein zwischen den zwei Objekten (102, 106) angeordnetes Verbindungselement (108, 208, 308) gebildet wird, welches zumindest einen ersten Material-abschnitt (116, 216, 316) aufweist, der intermetallische Verbindungen einer Phase umfasst, welche aus dem ersten Lötmetall und dem zweiten Metall gebildet wird, und **dadurch gekennzeichnet ist, dass** das Verbindungselement zumindest einen zweiten Materialabschnitt (118, 218, 318) aufweist, der sich von dem ersten Materialabschnitt (116, 216, 316) unterscheidet und sich aus einem dritten Metall zusammensetzt, wobei der zweite Materialabschnitt (118, 218, 318) in Kontakt mit den zwei Objekten (102, 106) ist.

10. Verfahren zum Verbinden nach Anspruch 9, welches des Weiteren vor dem Schritt der Inkontaktbringung des Lötelements (111) mit dem zweiten Metall (110) einen Schritt der Realisierung von mindestens zwei metallischen Wänden (110) auf Basis des zweiten Metalls in Kontakt mit mindestens dem einen (106) der zwei Objekte aufweist, und in welchem:
- während des Schritts der Inkontaktbringung des Lötelements (111) mit dem zweiten Metall (110) das Lötelement (111) zwischen den zwei metallischen Wänden (110) angeordnet wird; und
- der Schritt des Lötens zumindest zwei die intermetallischen Verbindungen umfassenden erste Materialabschnitte (116) bildet, wobei die zwei ersten Materialabschnitte (116) in Kontakt mit den zwei Objekten (102, 106) sind, der zweite Materialabschnitt (118) zwischen den zwei ersten Materialabschnitten (116) angeordnet ist, und jeder der zwei ersten Materialabschnitte (116) zwischen dem zweiten Materialabschnitt (118) und einer der zwei metallischen Wände (110) angeordnet ist.

11. Verfahren zum Verbinden nach Anspruch 9, welches darüber hinaus vor dem Schritt der Realisierung des Lötelements (111) einen Schritt der Realisierung eines oder mehrerer metallischer Lötstützpunkte bzw. Kontakte (210) auf Basis des zweiten Metalls in Kontakt mit dem einen (102) der zwei Objekte aufweist, wobei das Lötelement (111) so realisiert wird, dass es zumindest teilweise die metallischen Lötstützpunkte bzw. Kontakte (210) überdeckt, und in welchem der Schritt des Lötens einen oder mehrere die intermetallischen Verbindungen umfassende erste Materialabschnitte (216) bildet, wobei die ersten Materialabschnitte (216) zumindest teilweise die metallischen Lötstützpunkte bzw. Kontakte (210) überdecken und von dem zweiten Materialabschnitt (218) überdeckt sind.

12. Verfahren zum Verbinden nach Anspruch 9, welches des Weiteren vor dem Schritt der Realisierung des Lötelements (111) einen Schritt der Realisierung eines oder mehrerer metallischer Lötstützpunkte bzw. Kontakte (310) auf Basis des zweiten Metalls in Kontakt mit dem einen (106) der zwei Objekte aufweist, wobei das Lötelement (111) über dem anderen (102) der zwei Objekte realisiert ist, und in welchem:
- während des Schritts der Inkontaktbringug des Lötelements (111) mit dem zweiten Metall (110) das Lötelement (111) gegen die metallischen Kontakte (310) angeordnet wird; und
- der Schritt des Lötens einen oder mehrere die intermetallischen Verbindungen umfassende erste Materialabschnitte (316) aufweist, wobei die ersten Materialabschnitte (316) zumindes teilweise die metallischen Lötstützpunkte bzw. Kontakte (310) überdecken und von dem zweiten Materialabschnitt (318) überdeckt sind.

13. Verfahren zum Verbinden nach einem derAnsprüche 9 bis 12, in welchem die Realisierung des Lötelements (111) die Umsetzung der folgenden Schritte aufweist:
- Aufbringung bzw. Ablage des ditten Metalls (112) auf eines (102) der zwei Objekte;
- Aufbringung bzw. Ablage des ersten Lötmetalls (114) auf das dritte Metall (112);
- Wärmebehandlung des ersten Lötmetalls (114) und des dritten Metalls (112), wobei durch Diffusion im Festkörperzustand das Lötelement (111) gebildet wird, welches auf einer eutektischen Verbindung des ersten Lötmetalls und des dritten Metalls basiert.

14. Verfahren zum Verbinden nach einem der Ansprüche 9 bis 13, in welchem das erste Lötmetall Zinn aufweist, und/oder das zweite Metall Nickel oder Kupfer aufweist, und/oder das dritte Metall Gold aufweist.

15. Verfahren zum Verbinden nach einem der Ansprüche 9 bis 14, in welchem die zwei Objekte ein Substrat (102) und eine Abdeckung (106) sind, wobei zumindest ein Mikrosystem (100) fest mit dem Substrat (102) verbunden ist, wobei das Lötelement (111) in Form einer Wulst bzw. Naht realisiert ist, so dass der Schritt des Lötens eine Versiegelungsnaht bzw. Dichtungswulst (108, 208, 308) bildet, welche die Abdeckung (106) mechanisch mit dem Substrat (102) verbindet und hermetisch dichte Seitenwände eines Hohlraums (104) bildet, welcher zwischen dem Substrat (102) und der Abdeckung (106) gebildet ist und in welchem das Mikrosystem (100) eingekapselt ist.

## Claims

1. An assembly (10) of two objects (102, 106) integral with each other through at least one linking element (108, 208, 308) provided between both objects (102, 106), said linking element (108, 208, 308) including at least a first material portion (116, 216, 316) comprising intermetallic compounds of a phase formed with a first brazing metal and a second metal the melting point of which is higher than that of the first brazing metal, **characterized in that** said linking element (108, 208, 308) further includes at least a second material portion (118, 218, 318) separated from the first material portion (116, 216, 316) and composed of at least a third metal, said second material portion (118, 218, 318) contacting both objects (102, 106).

2. The assembly (10) according to claim 1, including at least two first material portions (116) comprising the intermetallic compounds, the two first material portions (116) contacting both objects (102, 106), the second material portion (118) being provided between the two first material portions (116).

3. The assembly (10) according to claim 2, further including at least two metal walls (110) composed of the second metal and contacting at least one (106) of both objects, each of the two first material portions (116) being provided between the second material portion (118) and one of the two metal walls (110).

4. The assembly (10) according to claim 3, wherein the two metal walls (110) are contacting both objects (102, 106).

5. The assembly (10) according to claim 1, including one or more first material portions (216, 316) comprising the intermetallic compounds, the first material portions (216, 316) contacting one of both objects (102, 106) and being covered with the second material portion (218, 318).

6. The assembly (10) according to claim 5, further including one or more metal pads (210, 310) composed of the second metal and contacting one of both objects (102, 106), each of the metal pads (210, 310) being at least partially covered with one of the first material portions (216, 316).

7. The assembly (10) according to one of the preceding claims, wherein the first brazing metal includes tin and/or the second metal includes nickel or copper, and/or the third metal includes gold.

8. The assembly (10) according to one of the preceding claims, wherein both objects are a substrate (102) and a cap (106), the assembly (10) further including at least a microsystem (100) integral with the substrate (102) and encapsulated in a cavity (104) formed between the substrate (102) and the cap (106), the linking element (108, 208, 308) being a sealing bead forming hermetic side walls of the cavity (104).

9. A method for assembling two objects (102, 106), including at least the steps of:
- making a brazing element (111) formed with at least a first brazing metal (114) and a third metal (112) on one (102) of both objects,
- contacting the brazing element (111) with at least a second metal (110, 210, 310) the melting point of which is higher than that of the first brazing metal (114),
- brazing both objects (102, 106) by isothermally solidifying the brazing element (111), forming at least one linking element (108, 208, 308) provided between both objects (102, 106), said linking element (108, 208, 308) including at least one first material portion (116, 216, 316) comprising intermetallic compounds of a phase formed with the first brazing metal and the second metal, and **characterized in that** said linking element comprises at least one second material portion (118, 218, 318) separated from the first material portion (116, 216, 316) and composed of the third metal, said second material portion (118, 218, 318) contacting both objects (102, 106).

10. The assembling method according to claim 9, further including, before the step of contacting the brazing element (111) with the second metal (110), a step of making at least two metal walls (110) composed of the second metal contacting with at least one (106) of both objects, and wherein:
- during the step of contacting the brazing element (111) with the second metal (110), the brazing element (111) is provided between said two metal walls (110), and
- the brazing step forms at least two first material portions (116) comprising the intermetallic compounds, the two first material portions (116) contacting both objects (102, 106), the second material portion (118) being provided between the two first material portions (116), and each of the two first material portions (116) being provided between the second material portion (118) and one of both metal walls (110).

11. The assembling method according to claim 9, further including, before the step of making the brazing element (111), a step of making one or more metal pads (210) composed of the second metal, contacting said one (102) of both objects, the brazing element (111) being made such that it at least partially covers the metal pads (210), and wherein the brazing step forms one or more first material portions (216) comprising the intermetallic compounds, the first material portions (216) at least partially covering the metal pads (210) and being covered with the second material portion (218).

12. The assembling method according to claim 9, further including, before the step of making the brazing element (111), a step of making one or more metal pads (310) composed of the second metal, contacting one (106) of both objects, the brazing element (111) being made on the other (102) of both objects, and wherein:
- during the step of contacting the brazing element (111) with the second metal (110), the brazing element (111) is provided against the metal pads (310), and
- the brazing step forms one or more first material portions (316) comprising the intermetallic compounds, the first material portions (316) at least partially covering the metal pads (310) and being covered with the second material portion (318).

13. The assembling method according to one of claims 9 to 12, wherein making the brazing element (111) includes implementing the following steps of:
- depositing the third metal (112) on one (102) of both objects,
- depositing the first brazing metal (114) on the third metal (112),
- heat treating the first brazing metal (114) and the third metal (112), forming through solid state diffusion the brazing element (111) which is composed of an eutectic composed of the first brazing metal and the third metal.

14. The assembling method according to one of claims 9 to 13, wherein the first brazing metal includes tin and/or the second metal includes nickel or copper and/or the third metal includes gold.

15. The assembling method according to one of claims 9 to 14, wherein both objects are a substrate (102) and a cap (106), at least one microsystem (100) being integral with the substrate (102), the brazing element (111) being made as a bead such that the brazing step form a sealing bead (108, 208, 308) mechanically connecting the cap (106) with the substrate (102) and forming hermetic side walls of a cavity (104) formed between the substrate (102) and the cap (106) and in which the microsystem (100) is encapsulated.
